Europäisches Patentamt

European Patent Office

Office européen des brevets

(11) Veröffentlichungsnummer: **0 501 466 A1**

# EUROPÄISCHE PATENTANMELDUNG

(21) Anmeldenummer: **92103321.3**

(51) Int. Cl.5: **H01J 37/32**, H05H 1/46

(22) Anmeldetag: **27.02.92**

(30) Priorität: **01.03.91 DE 9102438 U**

(43) Veröffentlichungstag der Anmeldung:
**02.09.92 Patentblatt 92/36**

(84) Benannte Vertragsstaaten:
**AT BE CH DE DK ES FR GB IT LI NL SE**

(71) Anmelder: **RÖHM GMBH**
**Kirschenallee**
**W-6100 Darmstadt(DE)**

(72) Erfinder: **Heinemann, Michael**
**Im Schöll 30/32**
**W-6115 Münster(DE)**
Erfinder: **Söder, Bernd, Dr.**
**Wilhelm-Leuschner-Strasse 11**
**W-6104 Seeheim-Jugenheim(DE)**
Erfinder: **Meier, Wolfgang**
**Werlacher Weg 32**
**W-6115 Münster(DE)**

(54) **Niederdruck-Plasmagenerator.**

(57) Zur Lokalisierung des Plasmas wird ein Niederdruck-Plasmagenerator, enthaltend eine Vakuumkammer und wenigstens eine Mikrowellen-Strahlenquelle, die selbst innerhalb der Vakuumkammer keine zur Plasmabildung ausreichende Feldstärke erzeugt, mit wenigstens einer Antenne für die Mikrowellen-Strahlung als Sekundärstrahler in der Vakuumkammer ausgerüstet.

EP 0 501 466 A1

Die Erfindung betrifft einen Niederdruck-Plasmagenerator mit lokalisierbarem Plasmabrennraum.

Die Behandlung mit Niederdruckplasmen ist eine wichtige neuere Methode zur Modifizierung der Oberfläche von festen Körpern. Die Oberflächen können z.B. geätzt, d.h. teilweise abgetragen, oder aktiviert, d.h. in einen energiereicheren, für weitergehende Modifizierungen geeigneten Zustand versetzt, oder durch Bindung von gasförmigen Stoffen beschichtet werden. Bei allen diesen Verfahren muß die zu modifizierende Oberfläche einem Plasma ausgesetzt werden. Als Plasma wird bekanntlich ein Gas aus angeregten Molekülen, Radikalen oder Ionen bezeichnet.

Plasmen lassen sich bei niedrigen Gasdrücken durch eine Mikrowellenstrahlung erzeugen. Voraussetzung für die Bildung eines Plasmas ist eine ausreichend hohe Feldstärke der Strahlung. Die Feldstärke ist in der unmittelbaren Nähe der Strahlungsquelle am größten und nimmt mit zunehmender Entfernung ab. Das Plasma entsteht daher nur in der Umgebung der Strahlungsquelle.

Die gleichmäßige Behandlung großer oder kompliziert gestalteter Oberflächen mit einem Plasma bereitet erhebliche Schwierigkeiten. Die verfügbaren Strahlungsquellen lassen sich aus Gründen ihrer konstruktiven Gestaltung und ihrer Energieversorgung nicht an jeder Stelle und in jeder Lage in einer Niederdruckkammer anordnen. Ebenso kann die zu behandelnde Oberfläche nicht immer an den vorgegebenen Ort des Plasmabrennraumes gebracht werden.

Die Fähigkeit zur Zündung und Aufrechthaltung eines Plasmas an einer vorbestimmten Stelle, an der es seine technische Wirkung entfalten soll, wird als Lokalisierung bezeichnet. Eine genaue Lokalisierung des Plasmas ist vor allem dann von großer Bedeutung, wenn eine große Fläche gleichmäßig behandelt werden soll. Dieses Ziel läßt sich weitgehend erreichen, wenn es gelingt, ein Plasma linienförmig gleichmäßig zu lokalisieren und dieses gleichmäßig über die zu behandelnde Oberfläche hinwegzuführen. Zu diesem Zweck kann entweder das Plasma ortsfest lokalisiert und das Substrat relativ dazu bewegt werden oder das Substrat bleibt unbewegt und das Plasma wird quer zu seiner Längserstreckung bewegt. Jedoch bereitet schon die lineare Lokalisierung eines gleichmäßigen Plasmas erhebliche Schwierigkeiten.

Es wird in der Literatur über verschiedene Möglichkeiten der Lokalisierung von Mikrowellenplasmen berichtet. Hierzu zählen u.a. das Zünden des Plasmas hinter dem Einlaßfenster für die Mikrowelle (Wertheimer et al., Thin Solid Films, 115 (1984), 109), das Zünden an den primären Sendeantennen (Alcatel DVM, 92240 Malakoff, Frankreich, Maschine GIR 820), das Zünden durch lokale Druckunterschiede in der Vakuumkammer (IKV-Mitteilungen, Hr. Ludwig) und der magnetische Einschluß mit oder ohne Ausnutzung der Elektron-Zyklotron-Resonanz-Absorption (EP-A 279 895). Einige dieser Möglichkeiten wurden auch zur Lokalisierung großflächiger Plasmen ausgenutzt.

Die Verwendung von Oberflächenwellen-Leiterstrukturen, die außerhalb einer Vakuumapparatur aber vor einem mikrowellen-durchlässigen Fenster montiert sind, erlaubt die Zündung eines großflächigen Plasmas (Kieser et al., Thin Solid Films, 118 (1984), 203).

Alle beschriebenen Methoden der Lokalisierung haben Nachteile, die ihrer praktischen Anwendung im Wege stehen. Der Nachteil der zuletzt beschriebenen Anordnung ist, daß das Plasma nur direkt hinter dem Fenster brennt und nicht durch den Operator an beliebige Orte innerhalb des Vakuums verschoben werden kann. Im Falle eines beschichtenden Plasmas wird auch das Fenster beschichtet, was je nach den Eigenschaften der deponierten Schicht zu einer Absorption und Reflektion der Mikrowelle führen kann. Durch wiederholtes Reinigen oder Austauschen der Fenster werden lange Rüstzeiten notwendig.

Das Zünden an den primären Sendeantennen ergibt ein Plasma, dessen Intensität in den meisten Fällen örtliche Inhomogenitäten aufgrund der Wellenlänge der Sendefrequenz aufweisen (z.B. mit einer Periode von 12 cm bei einer Frequenz von 2,45 GHz). Bedingt durch die Ausführung als primäre Sendeantennen sind bei dieser Anordnung kompensierende Vorrichtungen wie z.B. eine mechanische Bewegung der Antenne kaum anwendbar.

Die Lokalisierbarkeit des Plasmas durch lokale Druckunterschiede ist auf die Beschichtung weitgehend geschlossener Körper beschränkt. Zur Innenbeschichtung von Flaschen ist dies eine geeignete Methode. Für die Bearbeitung ebener Substrate ergeben sich schwerwiegende technische Schwierigkeiten.

Eine sehr erfolgreiche Methode ist der magnetische Einschluß. Dieses Verfahren wird z.B. in der Sputtertechnik eingesetzt. Ein wirkungsvoller magnetischer Einschluß ist aber nur gegeben, wenn der Gyrationsradius der geladenen Teilchen im Plasma gegenüber der freien Weglänge nicht vernachlässigbar ist. Dies ist bei konventionellen Permanentmagneten aus Ferriten nur unterhalb von Drücken von etwa 0,1 mbar der Fall.

## Aufgabe und Lösung

Mit Plasmen von höheren Drücken - bis zu einigen Millibar - lassen sich bei Ätz- und Beschichtungsverfahren höhere Ätz- bzw. Depositionsraten erreichen. Aus diesem Grund besteht Bedarf an einer Methode zum Plasmaeinschluß, die auch bei höheren Drücken eine gute Lokalisierbarkeit hat und dabei eine homogene Ätzung oder Schichtbildung bei gleichzeitig großen Ätz- bzw. Depositionsraten erlaubt.

Es wurde gefunden, daß ein Niederdruck-Plasmagenerator, der eine Vakuumkammer und wenigstens eine Mikrowellen-Strahlenquelle enthält, die gestellte Aufgabe dann erfüllt, wenn in der Vakuumkammer wenigstens eine Antenne für die Mikrowellen-Strahlung angeordnet ist. Die Antenne wirkt als Sekundärstrahler; seine Funktion besteht in der Absorption der Mikrowelle und der Erzeugung lokaler, großer Feldstärken, die zu der Zündung eines Plasmas in unmittelbarer Umgebung der Antenne führen.

Die Mikrowelle wird durch ein oder mehrere Fenster in die Vakuumkammer eingestrahlt. Wichtig ist, daß die Leistungsflächendichte der eingestrahlten Mikrowelle nicht ausreicht, um an den Fenstern ein Plasma zu zünden. Dies würde zu einer unerwünschten Absorption und Reflektion der Mikrowelle führen. Durch Einstrahlung an beliebig vielen Fenstern kann ausreichende Leistung zugeführt werden, um an dem Sekundärstrahler eine zur Zündung des Plasmas ausreichende Feldstärke zu erzeugen.

Die Erfindung wird durch die Figuren 1 bis 6 näher erläutert.

**Figur 1** zeigt schematisch einen Hertzschen Dipol als Sekundärstrahler.

**Figur 2** zeigt einen aus mehreren Antennen gebildeten Kammstrahler.

**Figur 3** zeigt verschiedene Möglichkeiten der Orientierung von Sekundärstrahlern zu einem zu behandelnden Substrat.

**Figur 4** zeigt schematisch einen aus vier Kammstrahlern gebildeten Flächenstrahler in der Aufsicht und Seitensicht.

**Figur 5** zeigt schematisch mehrere Möglichkeiten bewegter Sekundärstrahler.

**Figur 6** zeigt als Schnittbild einen als Primärstrahler wirksamen Niederdruck-Plasmagenerator mit eingebautem Kamm-Sekundärstrahler.

## Ausführung der Erfindung

Eine Mikrowellen-Strahlenquelle üblicher Bauart mit einer Frequenz von 1 bis 15 GHz ist vorzugsweise außerhalb der Vakuumkammer angeordnet. Bevorzugt ist eine Mikrowellenstrahlung mit einer Frequenz von 2,45 GHz, was einer Wellenlänge von 122,5 mm im Vakuum entspricht. Die Strahlung wird durch ein vakuumdichtes Fenster aus einem mikrowellen-durchlässigen Material, z.B. Duran[R]-Glas, in die Vakuumkammer eingekoppelt.

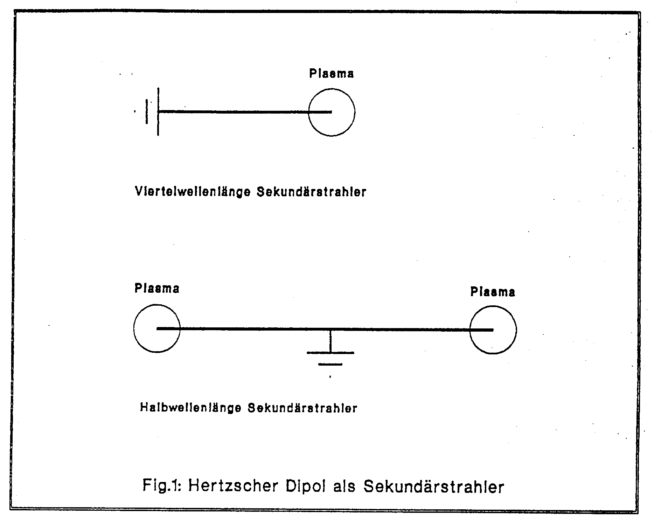

Die erfindungsgemäß als Sekundärstrahler wirkende Antenne muß zur Absorption der eingestrahlten Mikrowelle geeignet sein. Zweckmäßig ist eine Antenne, deren Länge einer viertel Wellenlänge oder einem Vielfachen davon entspricht. Ein möglicher Sekundärstrahler ist z.B. ein Hertzscher Dipol (Fig. 1). Bei Erdung in der Mitte des Dipols bildet sich eine stehende Welle dermaßen aus, daß die elektrische Feldstärke an den Enden maximal und der Strom hier minimal ist. Aufgrund der großen Feldstärken zündet an den Enden ein Plasma. Dieses Plasma brennt in einem Druckbereich von etwa 0,05 mbar bis über 50 mbar. Die Ausdehnung dieses ballartigen Plasmas an der Spitze des Dipols hängt vom Druck in der Vakuumkammer und von der Leistung der Mikrowelle ab.

Anstelle eines Hertzschen Dipols kann jede andere Antennenanordnung treten, die einerseits die Mikrowelle absorbiert und andererseits lokal eine ausreichend große Feldstärke erzeugt.

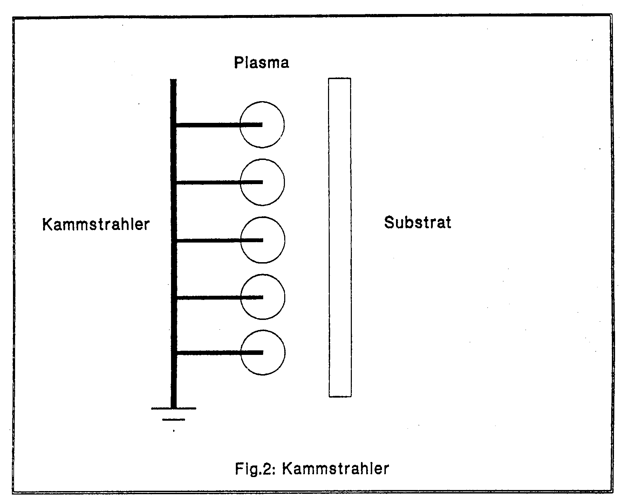

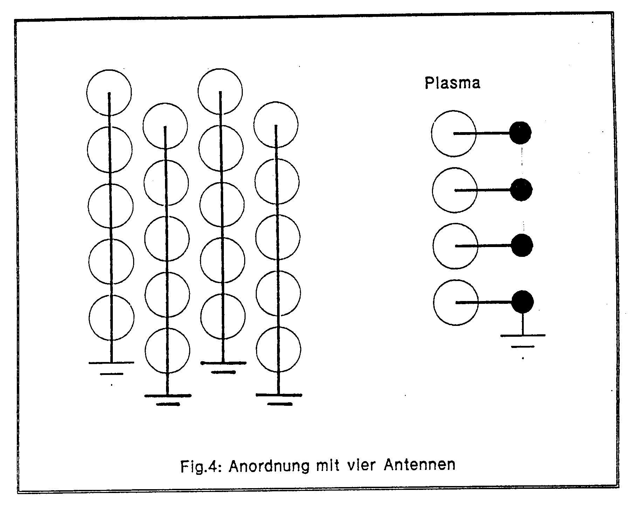

Eine Mehrzahl von Antennen kann als Kammstrahler entsprechend Figur 2 an einen gemeinsamem elektrischen Leiter bzw. eine Erdung angeschlossen sein. Vorzugsweise sind die Antennen an dem gemeinsamen Leiter im wesentlichen parallel zu einander in Abständen von 1/4 bis 1/20 der Wellenlänge angeordnet. Die Verbindungslinie der freien Antennenspitzen definiert etwa die Mittelachse des Plasmabrennraumes. Die freien Antennenspitzen können auf einer stetigen Kurve, z.B. einer Geraden, liegen, wodurch man ein linienförmiges Plasma erhält, mit dem man die Oberfläche eines Substrates mit entsprechendem Profil überstreichen kann. Eine Mehrzahl von Kammstrahlern, die alle an einen gemeinsamen Leiter angeschlossen sind, kann entsprechend Figur 4 so angeordnet sein, daß die freien Antennenspitzen in einer Ebene oder in einer stetig gekrümmten Fläche liegen. Mit derartigen Anordnungen kann die Form des Plasmabrennraumes der Oberflächenform des jeweiligen Substrates optimal angepaßt werden.

Ein großflächiges Plasma mit solchen Sekundärstrahlern kann auf verschiedene Weisen erzeugt werden. Einerseits können mehrere Sekundärstrahler, die in der Regel alle die gleiche Länge haben, in der Vakuumkammer angeordnet werden. Ihre kugelförmigen Plasmen überlagern sich zu einem großflächigen Plasma (Fig. 2). Bei der Anordnung der Sekundärstrahler muß berücksichtigt werden, daß die Sekundärstrahler ihrerseits elektromagnetische Strahlung emittieren. Bei der Verwendung von mehreren Sekundär-Strahlern kann dies zu Überlagerungen der Wellen führen. Dieser Effekt kann zur Erzeugung möglichst gleichmäßiger Plasmen ausgenutzt werden, indem Anordnungen der Sekundärstrahler gewählt werden, die eine gleichförmige Abstrahlung ergeben. Eine solche Antennenkonfiguration kann z.B. als Kamm, als Schneide oder als Yagi-Antenne gestaltet sein. Man versteht darunter eine Antenne aus mehreren miteinander gekoppelten Dipolen, wodurch die Empfangs- und Abstrahlcharakteristik verändert werden kann.

Sekundärstrahler der oben beschriebenen Art können überall in der Vakuumkammer angeordnet werden. Folglich ist es möglich, das dadurch erzeugte Plasma an einer beliebigen Stelle in der Vakuumkammer zu lokalisieren.

Das vorgestellte Verfahren ist nicht auf die Behandlung ebener Substrate beschränkt. Durch geeignete angepaßte Formgebung des Sekundärstrahlers können auch unregelmäßig geformte Bauteile mit komplizierter Geometrie modifiziert werden. Bahnförmige Substrate können erfindungsgemäß durch eine in der Vakuumkammer angeordnete Transportvorrichtung so durch ein brennendes Plasma geführt werden kann, daß das Plasma einen wesentlichen Teil der Fläche überstreicht.

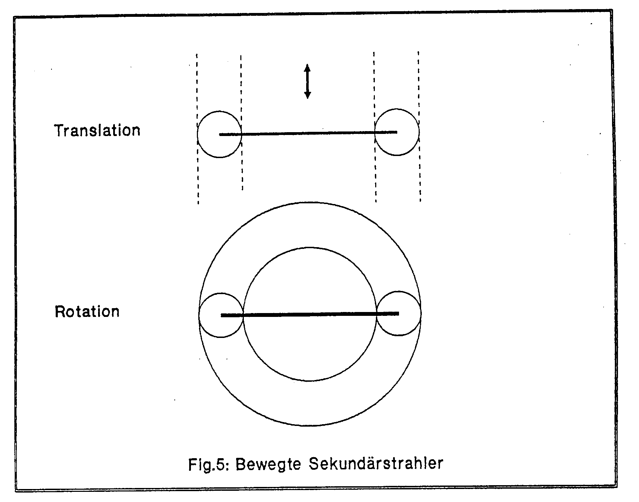

Eine weitere Möglichkeit zur Erzeugung einer großflächigen Modifikation durch das Plasma besteht in der Bewegung der Sekundärstrahler. Hierbei sind sowohl Translationen als auch Rotationen möglich (Fig. 5). Diese Bewegungen können so schnell ausgeführt werden, daß z.B. bei der Rotation ein torusförmiges Plasma entsteht. In diesem Fall wird allerdings nicht jeder Punkt des Torus zu jedem Zeipunkt mit Mikrowellenleistung versorgt. Dadurch kommt es für eine kurze Zeit zum Verlöschen des Plasmas an diesem Punkt. Befindet sich der betrachtete Punkt des Torus jedoch wieder im Bereich des kugelförmigen Plasmas, so werden die hier befindlichen Moleküle wieder angeregt. Dieser Wechsel von vorhandener Mikrowellen-Leistung an einem Ort entspricht einem gepulsten Plasma. Im Interesse einer möglichst gleichförmigen Oberflächenbehandlung kann die kontinuierliche Bewegung des Substrats mit einer Rotations- oder Translationsbewegung der Sekundärstrahler kombiniert werden. Zu diesem Zweck kann die Sekundärstrahleranordnung drehbar oder quer zur Bewegungsrichtung der Transportvorrichtung oszillierbar angeordnet sein.

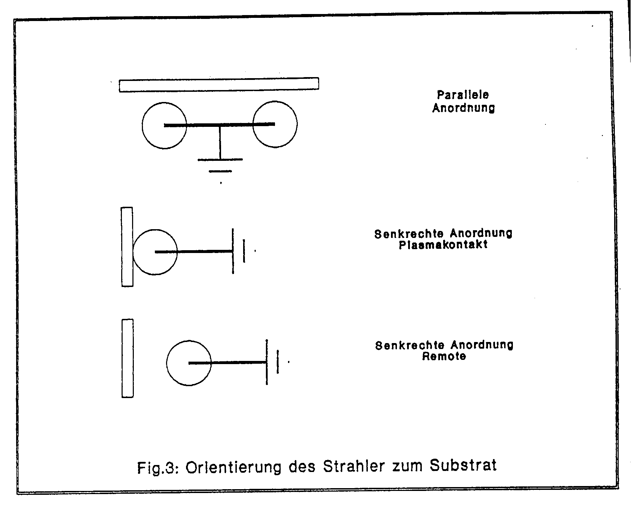

Das mit dem Plasma zu bearbeitende Substrat kann auf verschiedenen Weisen zu dem Strahler orientiert sein (Fig. 3). Entsprechend kann die Wirkung beeinflußt werden.

Je nach der angestrebten Einwirkung auf das Substrat kann dieses mit dem Plasmabrennraum in Berührung gebracht oder in dessen Nähe angeordnet sein. Dabei können die Antennen parallel oder senkrecht zum Substrat ausgerichtet sein. Durch die Verwendung mehrerer Antennen nebeneinander und Bewegung des Substrats senkrecht zu den Antennen können gegebenenfalls durch die Wellenlänge verursachte, periodische Inhomogenitäten ausgeglichen werden (Fig.4,5).

Niederdruck-Plasmageneratoren gemäß der Erfindung eignen sich für die an sich bekannten Plasma-Behandlungsverfahren, wie Aktivieren, Ätzen oder Beschichten. Zum Aktivieren wird beispielsweise eine Oberfläche einem Sauerstoff-Plasma ausgesetzt, wodurch polare Gruppen gebildet werden. Zur Plasma-Deposition wird das Plasma mit organischen Gasen gezündet, aus denen sich dünne Schichten mit wertvollen Eigenschaften auf der Substratoberfläche ausbilden. In Anordnungen mit erfindungsgemäßen Sekundärstrahlern können Depositionsraten bis zu einigen Mikrometern pro Minute erreicht werden.

**Primärstrahler mit eingebauten Sekundärstrahlern**

Die Erfindung kann auch dazu genutzt werden, ein Mikrowellenfeld mittels Sekundärstrahlern nicht zur unmittelbaren Bildung eines Plasmas, sondern zwecks Erzeugung einer großflächigen Strahlung anzuwenden. In diesem Fall steht die Vakuumkammer unter einem Druck, der zur Ausbildung eines Plasmas an den Antennenspitzen nicht geeignet ist. Er kann oberhalb oder unterhalb des zur Plasmabildung geeigneten Druckes, z.B. unter $10^{-5}$ oder über 100 mbar liegen. Die Mikrowellenstrahlung wird durch ein mikrowellendurchlässiges Fenster in eine dahinterliegende Vakuumkammer mit einem zur Plasmabildung geeigneten Druck eingestrahlt. Das Plasma brennt dann unmittelbar hinter dem Fenster.

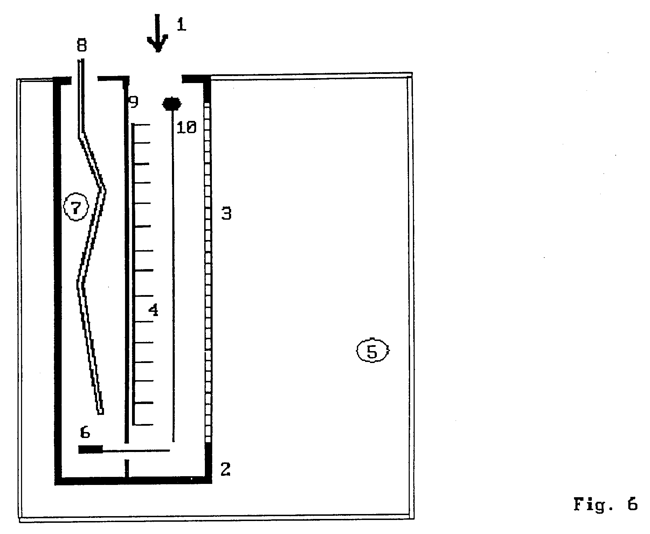

Eine zweckmäßige Gestaltung eines solchen Primärstrahlers geht aus Figur 6 hervor. Die Mikrowellenstrahlung einer Strahlungsquelle 1 wird in der Stirnseite eines Hohlleiters 2 eingekoppelt, der sich in einer Vakuumkammer 5 befindet. Eine oder mehrere parallele Kammantennen 4 sind darin parallel zum Wellenleitblech 9 so angeordnet, daß die Antennenspitzen auf ein vakuumdichtes, mikrowellendurchlässiges Fenster 3 gerichtet sind. Die Länge der Strahlerelemente der Kammantennen 4 beträgt bei einseitiger gemeinsamer Erdung etwa eine viertel Wellenlänge. Der Abstand der Elemente bestimmt den Antenneninnenwiderstand und bringt bei 1/5 bis 1/10 der Wellenlänge gute Ergebnisse. Durch Veränderung der Elementenlänge kann die Intensitätsverteilung des Plasmas außerhalb des Strahlers gesteuert werden.

Die Homogenität der abgestrahlten Mikrowellenstrahlung kann - allerdings auf Kosten des Wirkungsgrades - beträchtlich gesteigert werden, wenn am Antennenende ein Mikrowellenabsorber angeordnet ist. Stattdessen kann dort auch mittels eines modengerechten Kopplungsgliedes 6 die Strahlung ausgekoppelt und in einen besonderen Absorberraum 7 umgeleitet werden; eine Wasserschlange 8 ist ein geeigneter Absorber.

Das Plasma kann auch dadurch homogenisiert werden, daß die Strahlerelemente 4 durch einen angeregten Strahler 10 parallel zum Wellenleitblech 9 ersetzt werden. Der Strahler 10 ist mit dem Koppelglied 6 verbunden. Bei dieser Anordnung überlagert sich die Hohlleiterwelle mit der vom Strahler 10 ausgehenden Abstrahlung. Aufgrund der Beziehung

$$\Lambda = \Lambda_0[(1-[\Lambda_0/2a]^2)^{1/2}]^{-1}$$

worin die $\Lambda$ Hohlleiterwellenlänge, $\Lambda_0$ die Freiraumwellenlänge und a die Hohlleiterbreite sind, läßt sich die Hohlleiterwellenlänge bei 2,45 GHz auf z.B. 3 m einstellen, indem die Hohlleiterbreite a = 61 mm gewählt wird. Bei einer Plasmalänge von 70 cm wird die Freiraumwellenlänge von 0,122 stark unterdrückt. In diesem Falle spielt ein Absorber nur noch eine untergeordnete Rolle.

**Patentansprüche**

1. Niederdruck-Plasmagenerator, enthaltend eine Vakuumkammer und wenigstens eine Mikrowellen-Strahlenquelle, die selbst innerhalb der Vakuumkammer keine zur Plasmabildung ausreichende Feldstärke erzeugt, gekennzeichnet durch wenigstens eine Antenne für die Mikrowellen-Strahlung als Sekundärstrahler in der Vakuumkammer.

2. Niederdruck-Plasmagenerator nach Anspruch 1, gekennzeichnet durch eine Mehrzahl von Antennen in der Vakuumkammer.

3. Niederdruck-Plasmagenerator nach Anspruch 1 oder 2, dadurch gekennzeichnet, daß die freien Antennenspitzen auf einer stetigen Kurve liegen.

4. Niederdruck-Plasmagenerator nach Anspruch 3, dadurch gekennzeichnet, daß die freien Antennenspitzen auf einer Geraden liegen.

5. Niederdruck-Plasmagenerator nach Anspruch 4, dadurch gekennzeichnet, daß die freien Antennenspitzen in einer Ebene liegen.

6. Niederdruck-Plasmagenerator nach Anspruch 3, dadurch gekennzeichnet, daß die freien Antennenspitzen in einer stetig gekrümmten Fläche liegen.

7. Niederdruck-Plasmagenerator, nach einem oder mehreren der Ansprüche 2 bis 6, dadurch gekennzeichnet, daß die Antennen an einem gemeinsamen Leiter im wesentlichen parallel zu einander in Abständen von 1/4 bis 1/20 der Wellenlänge angeordnet sind.

8. Niederdruck-Plasmagenerator, nach einem oder mehreren der Ansprüche 1 bis 7, gekennzeichnet durch eine in der Vakuumkammer angeordnete Transportvorrichtung, mit der ein flächiges Substrat so durch ein brennendes Plasma geführt werden kann, daß das Plasma einen wesentlichen Teil der Fläche überstreicht.

9. Niederdruck-Plasmagenerator, nach Anspruch 8, dadurch gekennzeichnet, daß wenigstens ein Sekundärstrahler drehbar oder quer zur Bewegungsrichtung der Transportvorrichtung oszillierbar angeordnet ist.

10. Niederdruck-Plasmagenerator, nach Anspruch 4, 5 oder 7, dadurch gekennzeichnet, daß die Vakuumkammer unter einem Druck steht, der zur Ausbildung eines Plasmas nicht geeignet ist und daß die von dem Sekundärstrahler ausgehende Strahlung auf ein vakuumdichtes, mikrowellendurchlässiges Fenster gerichtet ist.

Fig.1: Hertzscher Dipol als Sekundärstrahler

Fig.2: Kammstrahler

Parallele
Anordnung

Senkrechte Anordnung
Plasmakontakt

Senkrechte Anordnung
Remote

Fig.3: Orientierung des Strahler zum Substrat

Fig.4: Anordnung mit vier Antennen

Translation

Rotation

Fig.5: Bewegte Sekundärstrahler

Fig. 6

Europäisches
Patentamt

# EUROPÄISCHER RECHERCHENBERICHT

Nummer der Anmeldung

EP 92 10 3321

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | EP-A-0 402 282 (ETAT FRANÇAIS (C.N.E.T.)) * Spalte 3, Zeile 15 - Spalte 6, Zeile 23; Abbildungen * | 1,2 | H01J37/32 H05H1/46 |
| | --- | | |
| A | FR-A-2 583 250 (ETAT FRANÇAIS (C.N.E.T.)) * Seite 6, Zeile 27 - Seite 9, Zeile 5; Abbildungen * | 1,2 | |
| | --- | | |
| A | EP-A-0 129 490 (ETAT FRANÇAIS (C.N.E.T.)) * Seite 7, Zeile 29 - Seite 8, Zeile 28; Abbildungen 3,4 * | 1,2 | |
| | --- | | |
| A | PATENT ABSTRACTS OF JAPAN vol. 15, no. 68 (C-807)18. Februar 1991 & JP-A-2 294 491 ( HITACHI LTD. ) 5. Dezember 1990 * Zusammenfassung * | 1,2,7 | |
| | ----- | | |

**RECHERCHIERTE SACHGEBIETE (Int. Cl.5)**

H01J
H05H

Der vorliegende Recherchenbericht wurde für alle Patentansprüche erstellt

| Recherchenort | Abschlußdatum der Recherche | Prüfer |
|---|---|---|
| DEN HAAG | 27 MAI 1992 | SCHAUB G.G. |